# FASCICULE DE BREVET EUROPEEN

(11) **EP 3 667 688 B1**
(45) Date de publication et mention de la délivrance du brevet: **17.04.2024**
(21) Numéro de dépôt: 19213452.6
(22) Date de dépôt: 04.12.2019
(51) Int. Cl.: H01G 2/04, H01G 2/08, H01G 4/224, H01G 9/06, H01G 9/08, H01G 11/18, H01G 11/82, H01G 4/32, H01G 9/15

(54) **ENSEMBLE ÉLECTRIQUE COMPRENANT UN ÉLEMENT CAPACITIF**
ELEKTRISCHE EINHEIT, DIE EIN KAPAZITIVES ELEMENT UMFASST
ELECTRICAL ASSEMBLY COMPRISING A CAPACITIVE ELEMENT

(30) Priorité: 14.12.2018 FR 1872984
(43) Date de publication de la demande: 17.06.2020
(73) Titulaire: Valeo eAutomotive France SAS, 95800 Cergy (FR)
(72) Inventeur: MORTAIN, Eloi, 92150 SURESNES (FR); MOCERI, Alwin, 78700 CONFLANS SAINTE-HONORINE (FR)
(74) Mandataire: Valeo Powertrain Systems

(56) Documents cités:
- WO-A1-2015/035799
- WO-A2-2021/255445
- KR-B1- 101 057 630
- US-A1- 2008 265 586

## Description

### DOMAINE TECHNIQUE ET OBJET DE L'INVENTION

La présente invention concerne un ensemble électrique comprenant notamment un élément capacitif et un boîtier et vise notamment un bloc capacitif.

La présente invention vise en particulier à améliorer la maîtrise des cotes de fabrication d'un tel ensemble électrique, notamment d'un bloc capacitif.

Un avantage de l'invention est de faciliter l'assemblage d'un tel ensemble électrique dans un équipement électrique, tel qu'un onduleur, notamment dans le domaine des systèmes de motorisation électrique pour véhicule.

L'invention vise notamment à permettre un assemblage adapté à la production en grande série de tels équipements électriques.

### ETAT DE LA TECHNIQUE

Comme cela est connu, dans un véhicule automobile électrique ou hybride, une batterie d'alimentation haute tension assure une fonction d'alimentation en énergie d'un système de motorisation électrique permettant la propulsion du véhicule. Afin d'être chargée, la batterie d'alimentation haute tension est par exemple connectée à un réseau électrique d'alimentation externe, notamment via un chargeur électrique comprenant au moins un convertisseur de tension continu-continu.

Afin de commander la machine électrique entrainant les roues du véhicule, il est connu d'utiliser un onduleur permettant de convertir le courant fourni par la batterie d'alimentation haute tension en un ou plusieurs courants de commande alternatifs, par exemple sinusoïdaux.

L'onduleur comprend un bloc capacitif permettant de lisser le courant fourni par la batterie d'alimentation, avant sa conversion en courants de commande alternatifs. Le bloc capacitif comprend un boîtier comprenant une cavité, dans laquelle est inséré un élément capacitif, destiné notamment à assurer le lissage du courant. Cet élément capacitif permet ainsi de supprimer les perturbations résiduelles du courant afin que ce courant puisse être converti en courants de commande alternatifs. Dans un bloc capacitif, l'élément capacitif est noyé dans son boîtier dans un matériau de remplissage, notamment une résine, assurant l'étanchéité et l'isolation électrique dudit élément capacitif. Le bloc capacitif comporte également au moins un connecteur électrique de sortie destiné à permettre une connexion électrique de l'élément capacitif avec un autre dispositif électrique. Ledit au moins un connecteur électrique est notamment soudé audit élément capacitif. Ledit connecteur électrique correspond à un conducteur électrique également désigné par le terme « leadframe » en langue anglaise. Un tel connecteur électrique est par exemple replié en vue de réaliser ladite connexion électrique de l'élément capacitif avec un autre dispositif électrique via une barre de connexion électrique dédiée.

L'onduleur comprend en outre un module électronique de puissance configuré pour réaliser la conversion du courant fourni par la batterie en courants alternatifs de commande injectés dans la machine électrique.

Comme cela est connu, dans un équipement électrique, un élément capacitif peut être disposé dans un boîtier et noyé dans un matériau de remplissage assurant principalement une fonction de maintien et de protection de l'élément capacitif vis-à-vis de l'humidité. Un tel matériau de remplissage se présente généralement sous la forme d'une résine.

Un tel équipement électrique comprenant un élément capacitif doit être refroidi de manière à dissiper la chaleur émise par l'élément capacitif. A cette fin, l'équipement électrique est disposé contre un circuit de refroidissement.

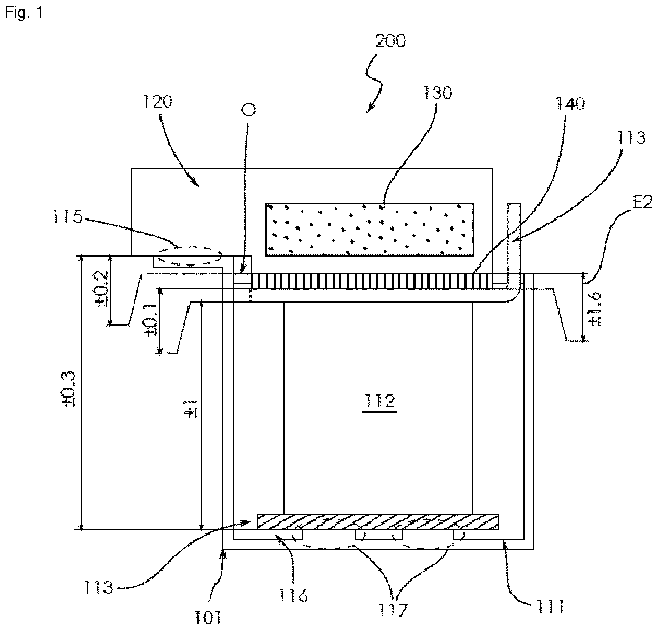

US 2008/265586 A1 divulgue un bloc capacitif comprenant un élément capacitif, un connecteur électrique solidarisé avec ledit élément capacitif par l'intermédiaire de connections électriques et un boîtier présentant un fond, une paroi latérale et une ouverture par laquelle l'élément capacitif est inséré, En pratique, en référence à la figure 1, représentative de l'état de la technique, dans un tel équipement électrique 200, l'élément capacitif 112 est placé dans un boîtier 111 présentant un fond, une paroi latérale et une ouverture par laquelle l'élément capacitif 112 est inséré dans le boîtier 111. Le boîtier 111 est pourvu de plots 117 aménagés sur le fond du boîtier 111. L'élément capacitif 112 repose sur ces plots 117. Côté opposé, des connecteurs électriques 113 de l'élément capacitif 112 sont soudés audit élément capacitif 112. L'élément capacitif 112 est destiné à être noyé dans un matériau de remplissage 116 du boîtier 111, en particulier une résine assurant l'étanchéité et l'isolation électrique de l'élément capacitif, ledit matériau de remplissage 116 étant également désigné « potting » en langue anglaise.

Cet ensemble 101 formé du boîtier 111 et de l'élément capacitif 112 pourvu de connecteurs électriques 113 est placé, par le côté correspondant à l'ouverture, contre un circuit de refroidissement 130, par exemple intégré à un châssis 120 d'un équipement électrique 200 englobant ledit ensemble 101. A cette fin, l'ensemble électrique 101 est fixé, par des moyens adaptés 115, au châssis 120.

Ainsi, dans le contexte d'un processus d'assemblage classique, le sous-ensemble 101 formant un bloc capacitif, est par exemple vissé sur un châssis principal, notamment le châssis d'un onduleur fournissant de l'énergie à un moteur électrique de véhicule.

Comme cela est connu, une interface thermique 140 est prévue entre l'élément capacitif 112 et les connecteurs électriques 113, d'une part, et le circuit de refroidissement 130 d'autre part. Une telle interface thermique 140 est notamment constituée de matériaux dont la conductivité thermique est élevée. Sa fonction est d'améliorer la dissipation thermique de la chaleur émanant des connecteurs électriques 113 de l'élément capacitif 112 vers le circuit de refroidissement 130. L'interface thermique 140 est en pratique un dissipateur thermique qui est disposé en contact avec le circuit de refroidissement 130. Comme cela est connu également, l'épaisseur de cette interface thermique 140 est imposée par des contraintes prédéterminées de dimensionnement, liées en particulier à la quantité de chaleur à dissiper en cours de fonctionnement.

L'état de la technique ne permet cependant pas de maîtriser totalement le niveau auquel se trouve le haut de l'ensemble 101 comprenant le boitier 111 et l'élément capacitif 112, notamment en raison des différentes tolérances de fabrication issues de chacune des pièces constituant l'assemblage, intrinsèquement liées au processus d'assemblage décrit plus haut, en regard de la figure 1. Plus particulièrement, la variabilité relative à la hauteur de l'élément capacitif 112 est élevée.

Or, comme cela est connu, dans l'état de l'art, la hauteur de l'interface thermique 140 est imposée par les cotes d'autres éléments de l'ensemble électrique, notamment du bloc capacitif. Outre la hauteur de l'élément capacitif 112, la hauteur du boîtier 111, celle des plots 117 sur lesquels repose l'élément capacitif 112 ont notamment un impact.

Avec les tolérances de fabrication inhérentes à chacun de ces éléments, on obtient en pratique des épaisseurs de l'interface thermique potentiellement très variables, à +/- 1,6 mm. Cette variabilité E2 induite sur l'épaisseur de l'interface thermique 140 constitue un inconvénient majeur car, notamment, si l'interface thermique 140 est trop mince, autrement dit trop comprimée, elle peut être percée, ce qui induirait une perte d'étanchéité de l'ensemble électrique 101. De même, si l'épaisseur de l'interface thermique 140 est trop importante, la fonction de dissipation thermique est moins bonne.

Or, une grande partie de la variabilité E2 de l'épaisseur de l'interface thermique 140, dans l'état de l'art, provient de la hauteur du bloc capacitif, ou, autrement dit, de l'ensemble électrique 101 composé d'un boîtier 111 et de l'élément capacitif 112 disposé dans ledit boîtier 111. En particulier, la hauteur de l'élément capacitif 112 présente une grande variabilité, due aux tolérances de fabrication, qui engendre une grande incertitude sur la hauteur l'épaisseur de l'interface thermique notamment. Ainsi, deux éléments capacitifs du même type, correspondant à un modèle identique, peuvent présenter des hauteurs différentes, typiquement à +/- 1 mm près.

Il existe donc un besoin pour un ensemble électrique comprenant un élément capacitif disposé dans un boîtier configuré de telle sorte que, tout en conservant une certaine souplesse sur les cotes de fabrication et en maintenant un encombrement minimal, la hauteur dudit ensemble électrique soit maîtrisée, de sorte que le niveau auquel aboutit le haut de l'élément capacitif, du côté de l'ouverture du boîtier, soit maîtrisé.

En répondant à ce besoin, notamment, l'épaisseur des interfaces thermiques destinées à être mises en oeuvre entre l'élément capacitif et ses connecteurs électriques et un circuit de refroidissement d'un châssis contre lequel ledit ensemble est disposé, est également maîtrisée.

A cette fin, il est proposé un ensemble électrique composé d'un boîtier dans lequel est disposé un élément capacitif comprenant des connecteurs électriques. Selon l'invention, ledit boîtier comprend un épaulement aménagé du côté de l'ouverture, ledit épaulement recevant en butée ledit au moins un connecteur électrique de l'élément capacitif.

### PRESENTATION GENERALE DE L'INVENTION

Plus précisément, l'invention a pour objet un ensemble électrique, notamment un bloc capacitif, comprenant un élément capacitif, au moins un connecteur électrique solidarisé avec ledit élément capacitif et un boîtier présentant un fond, une paroi latérale et une ouverture par laquelle l'élément capacitif est inséré, ledit boîtier comprenant au moins un épaulement du côté de l'ouverture, ledit épaulement formant une butée configurée pour recevoir en appui ledit au moins un connecteur électrique, de sorte à supporter ledit élément capacitif.

Avantageusement, l'élément capacitif est noyé dans un matériau de remplissage du boîtier, pour fixer l'élément capacitif dans ledit boîtier.

Selon un mode de réalisation, les épaulements sont des nervures formant des excroissances longitudinales issues de matière du boîtier, lesdites nervures présentant une extrémité, en retrait de l'ouverture, formant ladite butée configurée pour recevoir en appui ledit au moins un connecteur électrique.

Selon un mode de réalisation, le au moins un connecteur électrique présente une épaisseur inférieure à la distance entre l'épaulement et l'ouverture.

Selon un mode de réalisation, le boîtier comprend une cavité apte à loger l'intégralité de l'élément capacitif.

La présente invention vise également un équipement électrique comprenant un circuit de refroidissement et un ensemble électrique tel que brièvement décrit ci-dessus, ledit ensemble électrique étant monté sur le circuit de refroidissement de l'équipement électrique notamment par l'ouverture du boîtier.

Selon un mode de réalisation, ledit équipement électrique est configuré pour être embarqué dans un véhicule, et forme un onduleur configuré de manière à alimenter un moteur électrique entrainant le véhicule depuis une batterie, ou un convertisseur continu-continu configuré pour convertir une tension entre une batterie d'alimentation haute tension et une batterie d'alimentation basse tension, ou un chargeur électrique configuré pour convertir une tension entre un réseau électrique extérieur au véhicule et une batterie du véhicule.

L'invention vise aussi un procédé de fabrication d'un ensemble électrique tel que brièvement décrit ci-dessus, comprenant les étapes consistant à :
- fixer l'au moins un connecteur électrique sur au moins une borne de l'élément capacitif,
- positionner l'élément capacitif muni du connecteur dans le boitier, ledit connecteur venant en appui contre l'épaulement,
- remplir le boitier avec un matériau de remplissage fluide de manière à combler au moins en partie, voir complètement, l'espace entre l'élément capacitif et le boitier,
- durcir le matériau de remplissage, notamment par chauffage, de manière à fixer l'élément capacitif dans le boîtier.

Avantageusement, ledit au moins un connecteur électrique est soudé à l'élément capacitif, du côté de l'ouverture du boîtier.

### PRESENTATION DES FIGURES

L'invention sera mieux comprise à la lecture de la description qui va suivre, en se référant aux dessins annexés donnés à titre d'exemples non limitatifs, dans lesquels des références identiques sont données à des objets semblables et sur lesquels :
Fig. 1 (déjà décrite) est un schéma d'un équipement comprenant un ensemble électrique comportant un boîtier et un élément capacitif, avec une interface électrique prévue entre ledit ensemble et un châssis comprenant un circuit de refroidissement ;
Fig. 2 est un schéma d'un ensemble électrique correspondant, selon un exemple de l'invention ;
Fig. 3 représente une vue en perspective d'un boîtier d'un ensemble électrique selon un exemple de l'invention ; et
Fig. 4 montre une vue en perspective d'un ensemble électrique selon un exemple de l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE D'UNE FORME DE REALISATION DE L'INVENTION

Dans la description qui sera faite ci-après, l'invention sera décrite principalement en vue d'une mise en oeuvre dans un bloc capacitif, ou au moins dans un équipement électrique comprenant un élément capacitif disposé dans un boîtier, en particulier dans le contexte d'un équipement électrique destiné à un véhicule, notamment un véhicule automobile électrique ou hybride, sans que cela ne soit limitatif de la portée de la présente invention.

La présente invention concerne ainsi un équipement électrique comprenant un boîtier enveloppant au moins partiellement un élément capacitif. Une application particulière concerne un bloc capacitif comme décrit ci-dessus, sans que cette application ne puisse être considérée comme une limitation.

Le bloc capacitif comprend également au moins deux connecteurs, notamment un connecteur correspondant à la borne négative de l'élément capacitif et un connecteur correspondant à la borne positive de l'élément capacitif. Ces connecteurs permettent ainsi de donner un accès aux bornes négative et positive de la capacité, afin de connecter l'élément capacitif au reste du système.

D'autres équipements électriques, notamment de véhicule électrique ou hybride, tels qu'un convertisseur de tension continu-continu ou un chargeur électrique, peuvent également comporter de tels types de blocs capacitifs.

La figure 1 montre un équipement électrique 200 de l'art antérieur en vue schématique à deux dimensions, en tranche, vue de côté. L'équipement électrique 200 a déjà été décrit précédemment.

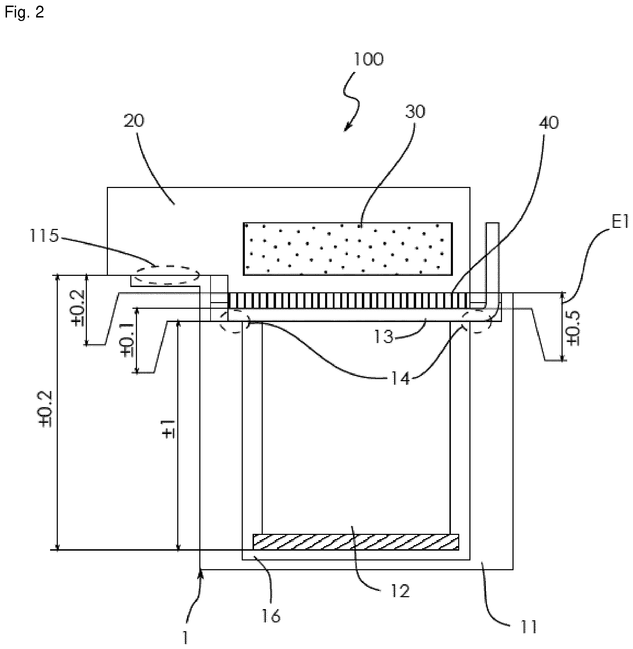

En référence à la figure 2, l'élément capacitif 12, au lieu d'être posé au fond du boîtier 11, sur des plots, vient en butée sur le haut du boîtier 11. Le matériau de remplissage 16 assure le maintien de l'élément capacitif 12. En outre, le matériau de remplissage 16 permet d'isoler électriquement l'élément capacitif 12 et d'assurer l'étanchéité dudit élément capacitif 12. Grâce à cela, l'équipement électrique 100 présente, entre l'ensemble électrique 1 formant un bloc capacitif et le circuit de refroidissement 20 qui peut être intégré à un châssis et comprend un bloc de refroidissement 30, une interface thermique 40 d'épaisseur maîtrisée. L'interface thermique 40 est notamment constituée d'un matériau flexible offrant une conductivité thermique élevée, par exemple de type gap pad^{®}. Alternativement, l'interface thermique 40 peut être constituée de graisse thermique.

Selon un exemple de l'invention, toujours en référence à la figure 2, une butée est réalisée au contact entre au moins un connecteur électrique 13 soudé à l'élément capacitif 12, sur le « haut » de ladite bobine 12, c'est-à-dire du côté de l'ouverture du boîtier 11, et au moins un épaulement 14 aménagé sur le « haut » du boîtier 11, c'est-à-dire du côté de l'ouverture O dudit boîtier 11.

La tolérance sur les cotes, liée à la fabrication, impactant en particulier la hauteur de l'interface thermique entre ledit au moins un connecteur électrique 13 de l'élément capacitif 12 et un circuit de refroidissement 20, ne dépend de ce fait plus que de l'épaisseur dudit au moins un connecteur 13 et de la hauteur de l'épaulement 14, c'est-à-dire de la distance entre l'épaulement 14 et l'ouverture O.

La butée étant organisée en haut du boîtier 11, le boîtier 11 peut aussi bien être un boîtier 11 dans lequel se loge l'intégralité de l'élément capacitif 12.

Grâce à l'appui du connecteur 13 sur le au moins un épaulement 14, l'élément capacitif 12 est supporté par ledit au moins un épaulement 14 et non par le fond du boîtier 11 comme c'est le cas dans l'art antérieur. Un espace subsiste entre la partie extrémale inférieure de l'élément capacitif 12, c'est-à-dire opposée à l'ouverture O du boîtier 11, et le fond du boîtier 11. Ainsi, cet espace peut absorber une incertitude sur la hauteur de l'élément capacitif 12 et permet donc d'avoir un dessus du bloc capacitif 12 qui reste à un niveau identique quelle que soit la variation de la hauteur de l'élément capacitif 12 par rapport à une hauteur nominale de référence.

Selon une forme de réalisation, le boîtier est constitué d'un matériau conducteur électrique, par exemple en aluminium. Dans ce cas, une feuille d'isolation électrique peut être disposée, en plus, entre d'une part l'élément capacitif 12 et le au moins un connecteur électrique 13 qu'elle comprend et d'autre part ledit boitier. Par exemple, l'ensemble électrique fait alors partie d'un équipement électrique tel qu'un onduleur et le boitier est un couvercle de l'onduleur.

Dans un mode de réalisation, le boîtier 11 est en plastique et il n'est pas nécessaire de prévoir une feuille d'isolation électrique supplémentaire.

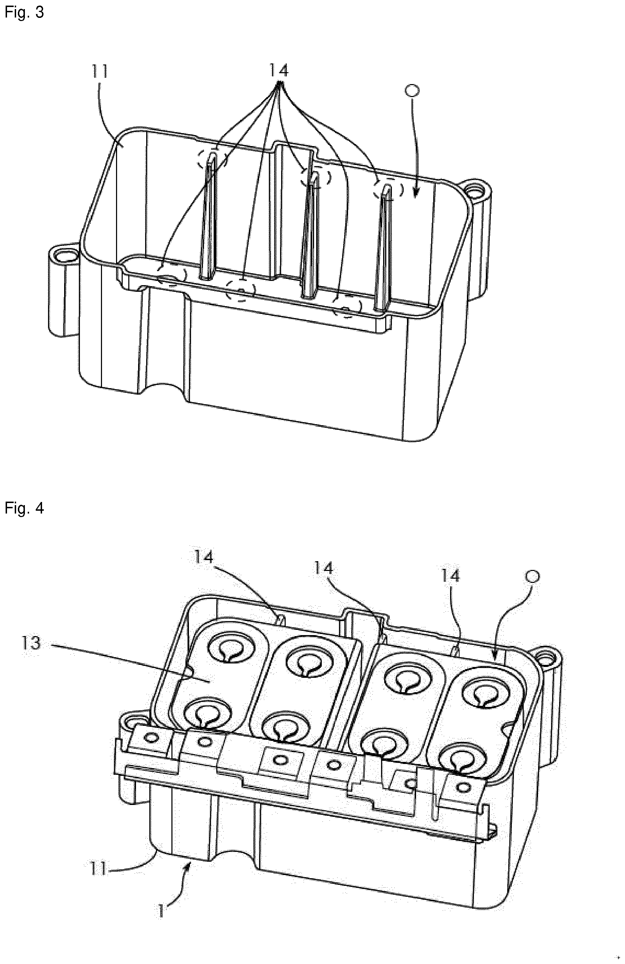

Sur les figures 3 et 4, il est représenté respectivement un boîtier 11 d'un ensemble électrique selon un exemple de l'invention et un tel ensemble électrique 1, dans lequel un élément capacitif 12 est logé dans le boîtier 11, au moins un connecteur électrique 13 soudé sur le haut de l'élément capacitif 12, c'est-à-dire du côté de l'ouverture du boîtier 11, repose sur des épaulements 14 aménagés sur le haut du boîtier 11.

Comme cela est montré sur les figures, grâce à l'invention, à iso-tolérance de fabrication des pièces mécaniques, la variabilité E1 potentiellement imposée à l'épaisseur de l'interface thermique 40 est réduite à +/- 0,5 mm, contre +/- 1,6 mm dans le cas de la figure 1, représentative de l'état de la technique.

Comme représenté sur les figures 3 et 4, les épaulements 14 sont par exemple des nervures formant des excroissances longitudinales dans le boîtier 11. L'élément capacitif 12 est prévu pour être inséré dans la cavité du boîtier 11. Les connecteurs électriques 13 soudés audit élément capacitif 12 viennent reposer en butée sur les épaulements 14. En particulier, l'élément capacitif 12 est ensuite noyé dans un matériau de remplissage, notamment une résine, qui occupe tout le volume disponible dans le boîtier. En se rigidifiant, ce matériau de remplissage maintient en place l'élément capacitif 12 dans le boîtier 11. Selon un mode de réalisation, le matériau de remplissage n'englobe pas l'intégralité de l'élément capacitif, mais n'en couvre qu'une partie, ce qui suffit à assurer son maintien.

L'ensemble électrique 1 ainsi constitué peut ainsi être disposé contre un circuit refroidissant par exemple. En particulier, en référence à la figure 2, l'ensemble électrique 1 est configuré pour être disposé contre un châssis comprenant un circuit de refroidissement 20. Une interface thermique 40, assurant une fonction d'amélioration de la dissipation thermique, est notamment interposée entre les connecteurs électriques 13 de l'élément capacitif 12 et ledit circuit de refroidissement 20.

L'ensemble électrique 1 étant prévu pour être fixé audit circuit de refroidissement 20 par des moyens 15 adaptés, ledit ensemble électrique 1 et ledit circuit de refroidissement 20 étant mis en contact l'un contre l'autre, ledit contact étant de type plan-plan, l'épaisseur de l'interface thermique 40 est contrainte. Grâce à l'invention, l'épaisseur de l'interface thermique 40 est toutefois contenue avec une précision améliorée par rapport à l'état de l'art, ladite épaisseur de l'interface thermique 40 n'étant impactée que par les tolérances de fabrication attachées à la hauteur des épaulements 14 et à l'épaisseur des connecteurs électriques 13 de l'élément capacitif 12.

Notamment, l'incertitude liée aux tolérances de fabrication attachées à la hauteur de l'élément capacitif 12 n'impacte plus ladite épaisseur de l'interface thermique 40. Par ailleurs, aucun plot n'est nécessaire au fond du boîtier 11 pour recevoir l'élément capacitif 12.

Selon un mode de réalisation, l'ensemble électrique peut être disposé sur un couvercle du châssis, notamment à l'aide de plots de guidage prévus sur ledit couvercle, et former avec ledit couvercle un ensemble, puis être assemblé sur le châssis comprenant notamment un circuit de refroidissement. Dans ce cas, ledit couvercle correspond au « boîtier » de l'ensemble électrique, ledit couvercle enveloppant partiellement ou totalement l'élément capacitif.

## Revendications

1. Ensemble électrique (1), notamment un bloc capacitif, comprenant un élément capacitif (12), au moins un connecteur électrique (13) solidarisé avec ledit élément capacitif (12) et un boîtier (11) présentant un fond, une paroi latérale et une ouverture (O) par laquelle l'élément capacitif (12) est inséré, ledit boîtier (11) comprenant au moins un épaulement (14) du côté de l'ouverture (O), ledit épaulement (14) formant une butée configurée pour recevoir en appui ledit au moins un connecteur électrique (13), de sorte à supporter ledit élément capacitif (12).

2. Ensemble électrique (1) selon la revendication 1, l'élément capacitif (12) étant noyé dans un matériau de remplissage (16) du boîtier (11), pour fixer l'élément capacitif (12) dans ledit boîtier (11).

3. Ensemble électrique (1) selon l'une quelconque des revendications précédentes, dans lequel les épaulements (14) sont des nervures formant des excroissances longitudinales issues de matière du boîtier (11), lesdites nervures présentant une extrémité, en retrait de l'ouverture (O), formant ladite butée configurée pour recevoir en appui ledit au moins un connecteur électrique (13).

4. Ensemble électrique (1) selon l'une quelconque des revendications précédentes, dans lequel le au moins un connecteur électrique présente une épaisseur inférieure à la distance entre l'épaulement et l'ouverture (O).

5. Ensemble électrique (1) selon l'une des revendications 1 à 4, le boîtier (11) comprenant une cavité apte à loger l'intégralité de l'élément capacitif (12).

6. Équipement électrique comprenant un circuit de refroidissement (20) et un ensemble électrique selon l'une des revendications précédentes, ledit ensemble électrique étant monté sur le circuit de refroidissement (20) de l'équipement électrique notamment par l'ouverture (O) du boîtier (11).

7. Equipement électrique selon la revendication précédente, pour un véhicule, formant un onduleur configuré pour alimenter un moteur électrique entrainant le véhicule depuis une batterie, ou formant un convertisseur continu-continu configuré pour convertir une tension entre une batterie d'alimentation haute tension et une batterie d'alimentation basse tension, ou formant un chargeur électrique configuré pour convertir une tension entre un réseau électrique extérieur au véhicule et une batterie du véhicule.

8. Procédé de fabrication d'un ensemble électrique (1) selon l'une des revendications 1 à 5, comprenant les étapes consistant à :
- fixer l'au moins un connecteur électrique (13) sur au moins une borne de l'élément capacitif (12),
- positionner l'élément capacitif (12) muni du connecteur (13) dans le boitier (11), ledit connecteur (13) venant en appui contre l'épaulement (14),
- remplir le boitier (11) avec un matériau de remplissage fluide de manière à combler au moins en partie, voir complètement, l'espace entre l'élément capacitif (12) et le boitier (11),
- durcir le matériau de remplissage, notamment par chauffage, de manière à fixer l'élément capacitif (12) dans le boîtier (11).

## Patentansprüche

1. Elektrische Einheit (1), insbesondere ein kapazitiver Block, umfassend ein kapazitives Element (12), mindestens einen elektrischen Verbinder (13), der mit dem kapazitiven Element (12) fest verbunden ist, und ein Gehäuse (11), das einen Boden, eine Seitenwand und eine Öffnung (O), durch die das kapazitive Element (12) eingeführt wird, aufweist, wobei das Gehäuse (11) mindestens eine Schulter (14) auf der Seite der Öffnung (O) umfasst, wobei die Schulter (14) einen Anschlag bildet, der dazu ausgestaltet ist, den mindestens einen elektrischen Verbinder (13) in Anlage aufzunehmen, so dass das kapazitive Element (12) getragen wird.

2. Elektrische Einheit (1) nach Anspruch 1, wobei das kapazitive Element (12) in ein Füllmaterial (16) des Gehäuses (11) eingebettet ist, um das kapazitive Element (12) in dem Gehäuse (11) zu fixieren.

3. Elektrische Einheit (1) nach einem der vorhergehenden Ansprüche, bei der die Schultern (14) Rippen sind, die längs verlaufende Vorsprünge bilden, die einstückig mit dem Gehäuse (11) sind, wobei die Rippen ein Ende aufweisen, von der Öffnung (O) zurückversetzt, das den Anschlag bildet, der dazu ausgestaltet ist, den mindestens einen elektrischen Verbinder (13) in Anlage aufzunehmen.

4. Elektrische Einheit (1) nach einem der vorhergehenden Ansprüche, bei welcher der mindestens eine elektrische Verbinder eine Dicke aufweist, die geringer als der Abstand zwischen der Schulter und der Öffnung (O) ist.

5. Elektrische Einheit (1) nach einem der Ansprüche 1 bis 4, wobei das Gehäuse (11) einen Hohlraum umfasst, der geeignet ist, das kapazitive Element (12) vollständig aufzunehmen.

6. Elektrische Ausrüstung, umfassend einen Kühlkreis (20) und eine elektrische Einheit nach einem der vorhergehenden Ansprüche, wobei die elektrische Einheit auf dem Kühlkreis (20) der elektrischen Ausrüstung montiert ist, insbesondere durch die Öffnung (O) des Gehäuses (11).

7. Elektrische Ausrüstung nach dem vorhergehenden Anspruch, für ein Fahrzeug, die einen Wechselrichter bildet, der dazu ausgestaltet ist, einen das Fahrzeug antreibenden Elektromotor von einer Batterie aus zu speisen, oder die einen Gleichspannungswandler bildet, der dazu ausgestaltet ist, eine Spannung zwischen einer Hochspannungsspeisebatterie und einer Niederspannungsspeisebatterie umzuwandeln, oder die ein elektrisches Ladegerät bildet, das dazu ausgestaltet ist, eine Spannung zwischen einem fahrzeugexternen Stromnetz und einer Batterie des Fahrzeugs umzuwandeln.

8. Verfahren zur Herstellung einer elektrischen Einheit (1) nach einem der Ansprüche 1 bis 5, umfassend die folgenden Schritte:
- Fixieren des mindestens einen elektrischen Verbinders (13) an mindestens einer Klemme des kapazitiven Elements (12),
- Positionieren des mit dem Verbinder (13) versehenen kapazitiven Elements (12) in dem Gehäuse (11), wobei der Verbinder (13) an der Schulter (14) in Anlage gelangt,
- Füllen des Gehäuses (11) mit einem flüssigen Füllmaterial, so dass der Raum zwischen dem kapazitiven Element (12) und dem Gehäuse (11) mindestens teilweise oder sogar vollständig ausgefüllt wird,
- Härten des Füllmaterials, insbesondere durch Erwärmen, so dass das kapazitive Element (12) in dem Gehäuse (11) fixiert wird.

## Claims

1. Electrical assembly (1), notably a capacitive unit, comprising a capacitive element (12), at least one electrical connector (13) secured to said capacitive element (12), and a housing (11) having a bottom, a sidewall and an opening (O) via which the capacitive element (12) is inserted, said housing (11) comprising at least one shoulder (14) on the side of the opening (O), said shoulder (14) forming an abutment surface configured so that said at least one electrical connector (13) can bear against it, so as to support said capacitive element (12).

2. Electrical assembly (1) according to Claim 1, the capacitive element (12) being embedded in a potting compound (16) with which the housing (11) is filled, so as to fix the capacitive element (12) in said housing (11) .

3. Electrical assembly (1) according to either one of the preceding claims, wherein the shoulders (14) are ribs forming projecting longitudinal extensions of the material of the housing (11), said ribs having an end, set back from the opening (O), forming said abutment surface and configured to have said at least one electrical connector (13) bearing against it.

4. Electrical assembly (1) according to any one of the preceding claims, wherein the at least one electrical connector has a thickness that is less than the distance between the shoulder and the opening (0).

5. Electrical assembly (1) according to one of Claims 1 to 4, the housing (11) comprising a cavity able to accommodate the entirety of the capacitive element (12).

6. Electrical equipment comprising a cooling circuit (20) and an electrical assembly according to one of the preceding claims, said electrical assembly being mounted on the cooling circuit (20) of the electrical equipment notably via the opening (O) of the housing (11).

7. Electrical equipment according to the preceding claim, for a vehicle, forming an inverter configured to power an electric motor that drives the vehicle from a battery, or forming a DC-DC converter configured to convert voltage between a high-voltage supply battery and a low-voltage supply battery, or forming an electric charger configured to convert a voltage between an electrical network external to the vehicle and a battery of the vehicle.

8. Method for manufacturing an electrical assembly (1) according to one of Claims 1 to 5, comprising the steps consisting in:
- fixing the at least one electrical connector (13) to at least one terminal of the capacitive element (12),
- positioning the capacitive element (12) equipped with the connector (13) inside the housing (11), said connector (13) coming to bear against the shoulder (14),
- filling the housing (11) with a fluid potting compound, so as to at least partially, if not completely, fill up the space between the capacitive element (12) and the housing (11),
- curing the potting compound, notably by heating, so as to fix the capacitive element (12) in the housing (11) .
